# EUROPÄISCHE PATENTSCHRIFT

(11) **EP 2 805 222 B1**
(45) Veröffentlichungstag und Bekanntmachung des Hinweises auf die Patenterteilung: **11.05.2016**
(21) Anmeldenummer: 13708342.4
(22) Anmeldetag: 11.01.2013
(51) Int. Cl.: G06F 3/044, H03K 17/96

(54) **KAPAZITIVER ANNÄHERUNGSSCHALTER**
CAPACITIVE PROXIMITY SENSOR
CAPTEUR DE PROXIMITÉ CAPACITIF

(30) Priorität: 20.01.2012 DE 102012001073
(43) Veröffentlichungstag der Anmeldung: 26.11.2014
(73) Patentinhaber: Oechsler Aktiengesellschaft, 91522 Ansbach (DE); PREH GmbH, 97616 Bad Neustadt a.d. Saale (DE)
(72) Erfinder: WEISSKOPF, Matthias, 91522 Ansbach (DE); SCHMIDT, Winfried, 91717 Wassertruedingen (DE); SCHULTHEIS, Thilo, 97616 Bad Neustadt (DE)
(74) Vertreter: Führing, Dieter
(86) Internationale Anmeldenummer: PCT/EP2013/000070
(87) Internationale Veröffentlichungsnummer: WO 2013/107622

(56) Entgegenhaltungen:
- US-A1- 2011 001 706
- BONSEN A ET AL: "HERAUSFORDERUNGEN IM KERAMIKSPRITZGIESSEN", KUNSTOFFE INTERNATIONAL, CARL HANSER VERLAG, MUNCHEN, DE, Bd. 93, Nr. 1, 1. Januar 2003 (2003-01-01) , Seiten 48-51, XP001097679, ISSN: 0023-5563
- PIOTTER V ET AL: "Recent developments in micro ceramic injection molding", INTERNATIONAL JOURNAL OF MATERIALS RESEARCH, CARL HANSER VERLAG, MUNCHEN, DE, Bd. 99, Nr. 10, 1. Oktober 2008 (2008-10-01), Seiten 1157-1162, XP001517089, ISSN: 1862-5282, DOI: 10.3139/146.101737
- MATTHIAS HARTMANN ET AL: "Ceramic injection molded clevis sensor for online substance concentration measurement", ELECTRONIC SYSTEM-INTEGRATION TECHNOLOGY CONFERENCE (ESTC), 2010 3RD, IEEE, PISCATAWAY, NJ, USA, 13. September 2010 (2010-09-13), Seiten 1-4, XP031806662, DOI: 10.1109/ESTC.2010.5642873 ISBN: 978-1-4244-8553-6

## Beschreibung

Die Erfindung betrifft einen kapazitiven ortsauflösenden Annäherungsschalter.

Aus der US 2011/0001706 A1 ist ein in einen Topf eingebautes Display mit ortsauflösendem Annäherungssensor bekannt. Ein Oberflächenbereich des Displays ist beispielsweise mit Elektroden als kapazitiven Sensoren bestückt. Über denen liegt eine, den Topf deckelartig abschließende, Glasscheibe als Bedienfläche. Eine an die Elektroden angeschlossene Sensorschaltung ist parallel zum Topf-Boden zwischen diesem und dem Display angeordnet.

Ein induktiver Näherungsschalter mit sinterkeramischer Abdeckung eines hohlzylindrischen Spritzguss-Kunststoffgehäuses, in dem ein Sensorspulensystem von hinter der Abdeckung angeformten Profilen gehaltert ist, ist aus der DE 2 99 07 642 U1 bekannt. Mit solchem induktiven Näherungsschalter wird eine Schweißanlage in der Kraftfahrzeug-Karosseriefertigung gesteuert. Der Keramikdeckel und das Gehäuse verhindern, dass sich Schweißspritzer an der Sensorspule anlagern, was deren Abstandsmessung im Zuge der Positionierung des Schweißwerkzeuges verfälschen würde. Damit vergleichbare Näherungsschalter mit solchen schweißresistenten Schutzdeckeln offenbaren die DE 37 17 932 A1 und die DE 42 21 987 A1. Nach der DE 20 2009 011 951 U1 wird für einen induktiven Näherungsschalter eine Sensorspule aus extrem dünnem Lackdraht dadurch gegen Feuchtigkeitseinflüsse geschützt, dass sie in einem hermetisch abgedichteten Keramiktopf innerhalb eines zylindrischen Außengehäuses betrieben wird.

Die DE 10 2010 005 663 A1 betrifft ein kapazitives Touchpanel mit einander geometrisch zugeordneten Elektroden auf der vorderen wie auch auf der rückwärtigen Oberfläche der als Dielektrikum dienenden, aus Glas, Keramik oder Kunststoff erstellten Frontblende eines Haushaltsgroßgerätes. Die dahinter gelegene Leiterplatte mit der Sensorschaltung ist aus Platzgründen bei kleinbauender Frontblende winklig bis senkrecht zu ihr orientiert.

Beim kapazitiven Schalter nach DE 20 2011 003 166 U1 dient eine Glas- oder Glaskeramikplatte als Schaltungsträger, welcher, der Schaltung gegenüber, mit einem konvexen Berührungskörper bestückt ist.

Aus der DE 20 2009 013 350 U1 ist ein kapazitiver Schalter insbesondere als stationäres Bedienteil in einem Kraftfahrzeug-Armaturenbrett bekannt. Etwa zum Verändern von vorgegebenen Temperatur- oder Geschwindigkeitswerten ist eine Bedienfläche in Form der Außenmantelfläche eines, im Vergleich zu seinem Durchmesser recht hohen, hohlkegelstumpf- bis topfförmigen, materialmäßig nicht näher spezifizierten Spritzgussteiles in der einen oder in der anderen Umfangsrichtung mit einer Fingerkuppe zu umfahren. Unter der Hohlkegelstumpf-Deckfläche sind orthogonal zu ihr sich erstreckende, elektrisch leitfähige stabförmige Elektroden verankert, die gegenüberliegend mechanisch an eine Leiterplatte und elektrisch an eine darauf ausgebildete Sensorschaltung angeschlossen sind. Letztere umfasst typischerweise einen kapazitiv verstimmbaren Oszillator. Erfasst wird dessen Frequenzänderung, wenn an Elektrodenstäben das jeweilige radiale elektrostatische Feld infolge Annäherung einer Fingerkuppe an die Außenmantelfläche des Kegelstumpfes beeinflusst wird. Das löst einen zugeordneten Schaltvorgang aus.

Solch ein nicht axialer sondern zentripetaler Annäherungsschalter hat sich bewährt; nachteilig kann aber die hohe Bauform infolge der achsparallel orientierten Stabelektroden und der Querschnittsraumbedarf für ein radiales Annähern an die Mantelfläche und daraufhin das Umfahren der Mantelfläche mit der Fingerkuppe sein, was Miniaturisierungs- und Einbaumöglichkeiten stark einschränkt.

Je nach der Empfindlichkeitsauslegung der Sensorschaltung eines solchen Schalters reagiert der erst auf dichtestmögliche Annäherung der Fingerkuppe an die Elektrodenumgebung - also praktisch erst auf Berührung der Mantelfläche des Kegelstumpfes - oder aber schon auf mehr oder weniger dichte bloße Annäherung; deshalb erstreckt im Rahmen vorliegender Erfindung der Begriff des Annäherungsschalters sich ohne Unterschied auch auf den Berührungsschalter. Entscheidend ist die kapazitive Auslösung des Schaltvorganges, ohne mechanisch zu bewegende Schalthandhaben.

Vorliegender Erfindung liegt die technische Problemstellung eines kompakteren aber dennoch vielseitigeren und sowohl haptisch wie auch visuell ansprechenderen Annäherungsschalters zugrunde, dessen Einsatz auch nicht mehr auf Aufbaumontage beschränkt sein soll.

Diese Aufgabe ist durch die Kombination der im Hauptanspruch angegebenen wesentlichen Merkmale gelöst. Danach ist die Bedienfläche des kapazitiven Annäherungsschalters keine zu umfahrende Mantelfläche mehr, sondern die problemlos axial zugängliche keramische Bodenfläche eines im Verhältnis zu seinem Durchmesser flachen Topfes; wobei ein solcher Topf im Rahmen vorliegender Erfindung nicht unbedingt einen runden Querschnitt aufweisen muss, sondern grundsätzlich auch mehreckig, etwa kastenartig, ausgebildet sein kann. Die unterhalb der Boden-Bedienfläche sich erstreckende Topf-Wandung weist Montage- und Befestigungsmittel wie insbesondere durchgehende oder blinde, fensterförmige Rasteingriffe für eine Einbaumontage des Annäherungsschalters auf.

Eine funktional selektive Schalterbetätigung erfolgt durch axial orientierte Annäherung wenigstens einer Fingerkuppe an wenigstens einen von gegeneinander versetzten Scheiben-Sektoren der Keramik-Bedienfläche, oder durch Überstreichen einander benachbarter solcher Sektoren. Zur Orientierungshilfe können erhabene oder eingesenkte Markierungen in der Bedienfläche, also in der Scheibenoberfläche vorgesehen sein. Diese Bedienfläche braucht im Übrigen nicht unbedingt plan zu sein, aus dekorativen, taktilen oder haptischen Gründen kann sie auch in ihrer Oberflächengeometrie oder in ihrem Oberflächenfinish regional ornamental unterScheibe hinterleuchtet. Die Stärke der Scheibe kann dabei lokal reduziert oder zum rückwärtigen Eingriff eines lokal entsprechend ausgeformten Lichtleiters durchbrochen sein.

Erfindungsgemäß handelt es sich, zumal für eine Massenproduktion, um eine Scheibe aus Spritzgusskeramik. Die kann, etwa mittels eines elastischen Entkopplungsringes, in ein Ende des Hohlzylinders der Topf-Wandung aus beliebigem Material montiert sein.
Aber auch solche Montage ist unter Umständen gerade für die Massenproduktion zu aufwendig. Bevorzugt ist deshalb ein integrierter flacher Topf aus scheibenförmiger Bedienfläche und hohlzylindrischer Montagewand einstückig aus Keramik gespritzt. Der optischen wie in gewisser Weise auch mechanischen Entkopplung zwischen Boden und Wandung dient eine längs des Scheibenrandes ringförmig umlaufende schmale Schattennut mit radial außerhalb sich anschließendem, auch die Hohlzylinderwand radial überragendem und über die Ebene der Bedienfläche aufragendem, angeformtem ringförmigem Wulst. Auch an solchem Ringwulst können erhabene oder eingesenkte taktile und optische Orientierungshilfen ausgebildet sein.
Als Spritzgusskeramik kommt grundsätzlich jeder anorganische nichtmetallische Werkstoff in Betracht. Problemlos geeignet ist Aluminiumoxid. Demgegenüber steigert der Einsatz des besonders zähen ZTA oder gar von reinem Zirkonoxid ganz markant die mechanische Festigkeit wie die Oberflächen-Abriebfestigkeit, aufgrund der Poliermöglichkeit auch die optische Qualität, der im Pulverspritzguss geformten, geometrisch komplexen Bedienumgebung des erfindungsgemäßen Annäherungsschalters.
Direkt unter der Keramikscheibe mit ihrer außen gelegenen Bedienfläche liegt im Hohlzylinder kraft- oder formschlüssig gehaltert die Sensorschaltung mit zur Keramikscheibe parallel orientierten flächenförmigen Elektrodensektoren. Zum Schutz der Sensorschaltung gegen Entladung einer auf hohes elektrostatisches Potential aufgeladenen Bedienperson ist die Sensorschaltung im Topf erfindungsgemäß von einem elektrischen Leiter umgeben, der zugleich als elastischer Puffer einer radialen Einbauumgebung gegenüber ausgelegt ist. Somit kann die Hohlzylinderwand in der Einbauebene der Schaltung, inner- oder außerhalb der Topf-Wandung, mit einem umlaufenden elektrischen Leiter in Lack-, Folien- oder Drahtausführung bestückt werden. Bevorzugt findet hier ein elektrisch leitend eingestellter oder beschichteter Kunststoffring gewisser Elastizität Einsatz, der auf die Topf-Wandung gespritzt oder montiert ist. Der dient dann zugleich als radialer Puffer gegen mechanische Beanspruchung und akustische Belästigung, die sonst auftreten würden, wenn der zwangsläufig unter geringem radialem Spiel montierte keramische Annäherungsschalter im Betrieb erschütterungsbedingt hart gegen seine Einbauumgebung anschlagen würde.

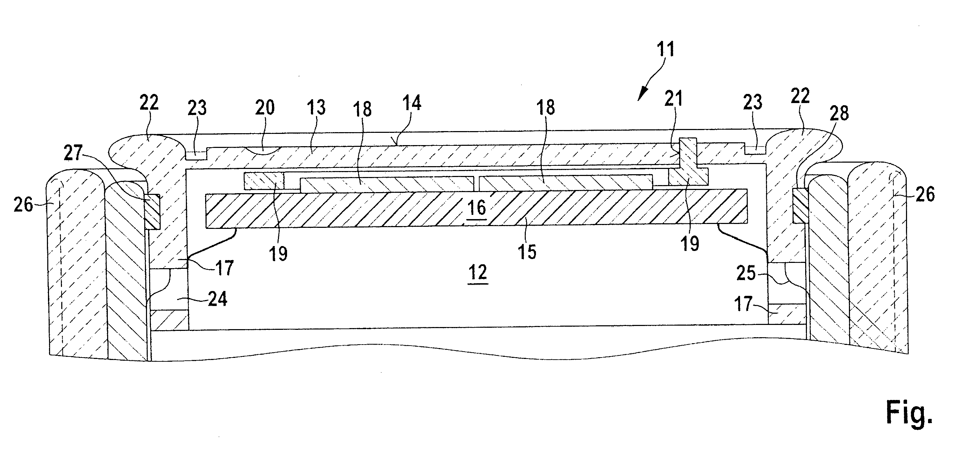

Zusätzliche Abwandlungen und weitere Alternativen im Rahmen der erfindungsgemäßen Lösung ergeben sich aus den weiteren Ansprüchen und, auch hinsichtlich deren Vorteilen, aus nachstehender Beschreibung eines bevorzugten Realisierungsbeispieles der Erfindung. Die einzige Figur der Zeichnung zeigt in auf das Funktionswesentliche abstrahierter, nicht ganz maßstabsgerechter Skizze einen eingebauten einstückigen kapazitiven Keramik-Annäherungsschalter im Radial-Querschnitt.

Der Annäherungsschalter 11 ist, was seine Bedienumgebung betrifft, als einstückiger flacher Topf 12 in Spritzgusstechnologie aus Keramik gefertigt. Die Außenseite einer Keramik-Scheibe, hier in Form des axial zugänglichen Topf-Bodens 13, dient als Bedienfläche 14, mittels derer der Schalter 11 auf Annäherung oder Berührung mit der Kuppe wenigstens eines Fingers (nicht dargestellt) reagiert. Dabei muss die Bedienfläche 14 nicht wie beispielshalber skizziert eben sein, je nach den gestalterischen oder handhabungstechnischen Vorgaben kann sie auch konvex, konkav oder sonstwie komplex dreidimensional zusammen mit sie umgebender, axial kurzer Wandung 17 einstückig gespritzt sein.

Unter dem Boden 13 ist eine Platine 15 oder dergleichen Träger für eine Sensorschaltung 16 innerhalb der Topf-Wandung 17 kraft- oder formschlüssig gehaltert, etwa wie symbolisch skizziert nach axialem Vorschub in Richtung gegen den Boden 13 eingerastet. Die Sensorschaltung 16 ist an flächige Elektrodensektoren 18 angeschlossen, die dicht unterhalb des Bodens 13 parallel zu diesem orientiert sind. Eine Elektroden-Unterteilung in etwa zwei, vier oder gar mehr Sektoren - oder ein andersartiges Design - liefert die Ortsempfindlichkeit bei axialer Annäherung einer Fingerkuppe an einen bestimmten Bereich der geschlossenen Bedienfläche 14 in Form des durchgehenden Bodens 13. Wenn konstruktionsbedingt der axiale lichte Abstand zwischen den Elektroden 18 und dem Dielektrikum in Form des Keramikbodens 13 nicht hinreichend klein gehalten werden kann, dann kann örtlich, auf die einzelnen Elektroden-Sektoren 18 oder diesen zugeordnet unter die Keramikscheibe 13, jeweils ein lokaler Hügel oder dergleichen Annäherung aus elektrisch leitendem Material zu örtlicher Abstandsverringerung montiert werden oder angespritzt sein (in der Zeichnung nicht berücksichtigt). Solch eine Maßnahme zur Abstandsverringerung braucht sich also nicht über die gesamte Geometrie des jeweiligen Elektrodensektors 18 zu erstrecken.

Zu optischer oder taktiler Unterscheidung der unterschiedlichen Funktionsbereiche kann die an sich integrale Bedienfläche 14 optische oder taktile Markierungen wie lokale Erhebungen und Einsenkungen, oder etwa hinsichtlich Einfärbung oder Oberflächenrauigkeit flächige Finishunterschiede, aufweisen. In der Beispielsdarstellung ist ein unter dem Boden 13 längs dessen Randes, etwa unter einer Schattennut 23, umlaufender Lichtleiter 19 vorgesehen, bei dem es sich aber auch um eine lückende Folge von Lichtquellen handeln kann. Zu großflächigerer leuchtender Darbietung von Bedienungshilfen durchstrahlt der hier ringförmig verlaufende Lichtleiter 19 wie skizziert gegen den Rand versetzt die Geometrie lokaler Verjüngungen 20 im Topf-Boden 13, oder er greift in Boden-Durchbrechungen 21 mit vorkragenden Bereichen entsprechender Geometrie ein.

Gleichartige Orientierungshilfen können in einem den Boden 13 axial und die hohlzylindrische Wandung 17 radial überragenden Wulst 22 vorgesehen sein. Der geht in die Wandung 17 unmittelbar über, aber in den Boden 13 vorzugsweise mit einer diesen umgebenden schmalen dreieck- oder wie übertrieben groß veranschaulicht rechteckförmigen Schattennut 23.

Da dieser Annäherungsschalter 11 nur axial, nicht (auch) radial bedient wird, kann er mit seiner Wandung 17 in eine beliebige Montageumgebung eingesenkt werden. Rasthaken 25 oder dergleichen Montagemittel greifen dann etwa in fensterförmige Rastöffnungen 24 in der Wandung17 ein.

Insbesondere kann die Einbauumgebung ein manuell, mittels Fingerkuppen, längs seiner Führungsmanschette verdrehbarer Stellring 26 eines Multifunktionsschalters etwa auf der Mittelkonsole eines Kraftfahrzeugs sein. Die aktuelle Funktion eines Verdrehens des Stellringes 26 kann etwa vorab mit einer Fingerkuppe über die Bedienfläche 14 des Annäherungsschalters 11 vorgewählt werden; oder eine erfolgte Dreheinstellung wird anschließend über die Bedienfläche 14 einer bestimmten Schaltungsfunktion zugeordnet.

In der Zeichnungsskizze ist berücksichtigt, dass es zum Ableiten elektrostatischer Aufladung einer Bedienperson zweckmäßig ist, in der Axialebene der Sensorschaltung 16 längs des inneren oder äußeren Umfanges der hohlzylindrischen Topf-Wandung 17 einen elektrischen Leiter 27 anzuordnen. Der kann die Form einer aufgebrachten Leitlackbanderole, einer auf- oder eingelegten Leitfolie oder umlaufender Drahtwindungen einer elastisch aufweitbaren Schaubenfeder aufweisen. Derartige Leiter 27 sind etwa über radiale Positionierungs-Nasen hinweg auf oder in die Hohlzylinder-Wandung 17 geschoben. Es kann sich auch um einen elektrisch leitend eingestellten oder beschichteten Kunststoff-Ring handeln, mit dem die Wandung 17 umspritzt ist. Skizziert ist ein nutförmig umlaufender Einschnitt 28 zu axialer und radialer Festlegung des Abschirm-Leiters 27 in Form eines elastischen Ringes, der über die äußere Mantelfläche der Wandung 17 radial etwas übersteht. Dadurch überbrückt er den Ringspalt zwischen dem Annäherungsschalter 11 und seiner Einbauumgebung, hier in Form des Stellringes 26 mit seiner innenliegenden Führungsmanschette, und wirkt so als radialer Puffer gegen ein etwa betriebs- und umweltbedingtes direktes Aufeinanderschlagen der radial einander distanziert benachbarten Konstruktionsteile.

So weist erfindungsgemäß ein haptisch wie optisch hochwertiger ortsauflösender kapazitiver Annäherungsschalter 11 eine mit Elektrodensektoren 18 hinterlegte Keramikscheibe auf, bei der es sich um den Boden 13 eines einstückig im Keramik-Spritzgussverfahren erstellten flachen Topfes 12 handelt. Definierte Oberflächenstrukturen der Bedienfläche 14 auf dem von außen axial zugänglichen Topf-Boden 13 dienen insbesondere einer taktilen, durchleuchtete Bereiche des Bodens 13 einer optischen Bedienerführung. Zum Ableiten der elektrostatischen Aufladung einer Bedienperson ist die Sensorschaltung 16 im Topf 12 von einem elektrischen Leiter 27 umgeben, der zugleich als elastischer Puffer einer radialen Einbauumgebung gegenüber ausgelegt ist. Dieser Annäherungsschalter 11 kann insbesondere vorteilhaft in den Stellring 26 eines Multifunktionsschalters eingesenkt werden.

### Bezugszeichenliste

- 11: Annäherungsschalter (mit 11 und 15)
- 12: Topf (aus 13 und 17)
- 13: Boden (von 12)
- 14: Bedienfläche (Außenseite von 13)
- 15: Platine (unter 13 für 16, 18)
- 16: Sensorschaltung (auf oder in 15)
- 17: Wandung (von 12)
- 18: Elektrodensektoren (zwischen 15 und 13)
- 19: Lichtleiter (unter 13, zum Durchstrahlen von 20, 21)
- 20: axiale Verjüngung (von 13 über 19)
- 21: Durchbrechung (in 13 für 19)
- 22: Wulst (zwischen 23 und 17)
- 23: Schattennut (in 13 zwischen 14 und 22)
- 24: Rastöffnung (in 17)
- 25: Rasthaken (zum Eingriff in 24)
- 26: Stellring (mit Aufnahme von 11 in seiner Führungsmanschette)
- 27: Leiter (längs 17 in der Ebene von 16)
- 28: Einschnitt (in 17 umlaufend, zur Aufnahme von 27)

## Patentansprüche

1. Kapazitiver ortsauflösender Annäherungsschalter (11) mit einer nicht unbedingt planen Scheibe als Bedienfläche (14), die den Boden (13) eines durch eine Wandung (17) und die Scheibe definierten Topfes (12) darstellt, und mit einer bedienungsabgewandt innerhalb der Wandung (17) angeordneten Sensorschaltung (16), die an Elektrodensektoren (18) angeschlossen ist, welche innerhalb der Wandung (17) parallel zum Boden (13) orientiert sind, wobei sich die Wandung (17) unterhalb des Bodens (13) erstreckt, **dadurch gekennzeichnet, dass** die Scheibe aus Spritzguss-Keramik besteht und die Wandung mit Montage- und Befestigungsmitteln wie Rastöffnungen (24) für eine Einbaumontage des Annäherungsschalters (11) ausgestattet ist, und wobei die Sensorschaltung (16) von einem außerhalb der Wandung (17) umlaufenden elektrischen Leiter (27) umgeben ist, der als elastischer radialer Puffer ausgelegt ist.

2. Annäherungsschalter nach dem vorangehenden Anspruch, **dadurch gekennzeichnet, dass** der Leiter (27) ein elektrisch leitend beschichteter oder eingestellter Kunststoff-Ring ist.

3. Annäherungsschalter nach einem der beiden vorangehenden Ansprüche, **dadurch gekennzeichnet, dass** der Leiter (27) ein Kunststoff-Ring ist, mit dem die Wandung (17) in einem nutförmig umlaufenden Einschnitt (28) umspritzt ist.

4. Annäherungsschalter nach einem der vorangehenden Ansprüche, **dadurch gekennzeichnet, dass** er zu Einsenken in eine Montageumgebung, insbesondere in einen Stellring (26), ausgelegt ist.

5. Annäherungsschalter nach einem der vorangehenden Ansprüche, **dadurch gekennzeichnet, dass** ein axialer Abstand zwischen dem Topf-Boden (13) und den Elektrodensektoren (18) lokal verringert ist.

6. Annäherungsschalter nach einem der vorangehenden Ansprüche, **dadurch gekennzeichnet, dass** er einen mit Scheibe und Wandung (17) einstückigen flachen Topf (12) aus Keramik in Spritzgusstechnologie aufweist.

7. Annäherungsschalter nach einem der vorangehenden Ansprüche, **dadurch gekennzeichnet, dass** eine längs des Bodens (13) ringförmig umlaufende Schattennut (23) mit einem radial außerhalb sich anschließenden, auch die Wandung (17) radial überragenden und über die Ebene der Bedienfläche (14) aufragenden, angeformten ringförmigen Wulst (22) vorgesehen sind.

8. Annäherungsschalter nach dem vorangehenden Anspruch, **dadurch gekennzeichnet, dass** der Wulst (22) in die Wandung (17) unmittelbar, aber in den Boden (13) mit einer diesen umgebenden, dreieck- oder rechteckförmigen Schattennut (23).übergeht.

9. Annäherungsschalter nach einem der vorangehenden Ansprüche, **dadurch gekennzeichnet, dass** die Bedienfläche (14) und / oder ein diese umgebender Wulst (22) Elektrodensektoren (18) geometrisch zugeordnete optische oder taktile Markierungen aufweist.

10. Annäherungsschalter nach einem der vorangehenden Ansprüche, **dadurch gekennzeichnet, dass** bedienungsabgewandt hinter dem Topf-Boden (13) längs dessen Randes ein umlaufender Lichtleiter (19) oder eine Folge von Lichtquellen angeordnet ist.

## Claims

1. Capacitive spatially resolving proximity switch (11) with a not necessarily planar panel as an operating surface (14), which represents the base (13) of a pot (12) defined by a wall (17) and the panel, and with a sensor circuit (16), which is arranged away from the operating side within the wall (17) and is connected to electrode sectors (18), which are oriented parallel to the base (13) within the wall (17), the wall (17) extending under the base (13), **characterized in that** the panel consists of injection-moulded ceramic and the wall is provided with mounting and fastening means such as snap-in openings (24) for built-in mounting of the proximity switch (11), and the sensor circuit (16) being surrounded by an electrical conductor (27), which runs around outside the wall (17) and is designed as an flexible radial buffer.

2. Proximity switch according to the preceding claim, **characterized in that** the conductor (27) is an electrically conductively coated or adjusted plastic ring.

3. Proximity switch according to one of the two preceding claims, **characterized in that** the conductor (27) is a plastic ring, with which the wall (17) is encapsulated in an incision (28) running around in the form of a groove.

4. Proximity switch according to one of the preceding claims, **characterized in that** it is designed for embedding in a mounting surrounding, in particular in an adjusting ring (26).

5. Proximity switch according to one of the preceding claims, **characterized in that** an axial distance between the pot base (13) and the electrode sectors (18) is locally reduced.

6. Proximity switch according to one of the preceding claims, **characterized in that** it has a shallow pot (12) formed integrally with the panel and the wall (17) from ceramic by injection-moulding technology.

7. Proximity switch according to one of the preceding claims, **characterized in that** a broad root with chamfer (23) running around annularly along the base (13), with a formed-on annular bead (22) adjoining radially outside, also projecting radially beyond the wall (17) and rising up beyond the plane of the operating surface (14) is provided.

8. Proximity switch according to the preceding claim, **characterized in that** the bead (22) goes over into the wall (17) directly, but goes over into the base (13) with a triangular or rectangular broad root with chamfer (23),surrounding the base.

9. Proximity switch according to one of the preceding claims, **characterized in that** the operating surface (14) and/or a bead (22) surrounding it has visual or tactile markings geometrically assigned to electrode sectors (18).

10. Proximity switch according to one of the preceding claims, **characterized in that** a running-around light guide (19) or a series of light sources is arranged facing away from the operating side behind the pot base (13) along the periphery thereof.

## Revendications

1. Détecteur de proximité (11) à déclenchement local capacitif comprenant, en tant que surface de commande (14), une plaque qui n'est pas nécessairement plane, laquelle représente le fond (13) d'un creuset (12) défini par une paroi (17) et la plaque, et comprenant un circuit détecteur (16) disposé à l'opposé de la commande à l'intérieur de la paroi (17), lequel est raccordé à des secteurs d'électrode (18) qui sont orientées parallèlement au fond (13) à l'intérieur de la paroi (17), la paroi (17) s'étendant au-dessous du fond (13), **caractérisé en ce que** la plaque est constituée de céramique moulée par injection et la paroi est équipée de moyens de montage et de fixation, comme des ouvertures d'enclipsage (24), pour un montage d'installation du détecteur de proximité (11), et le circuit détecteur (16) étant entouré d'un conducteur électrique (27) circonférentiel à l'extérieur de la paroi (17), lequel est réalisé sous la forme d'un tampon radial élastique.

2. Détecteur de proximité selon la revendication précédente, **caractérisé en ce que** le conducteur (27) est un anneau en matière plastique à revêtement ou à réglage électriquement conducteur.

3. Détecteur de proximité selon l'une des deux revendications précédentes, **caractérisé en ce que** le conducteur (27) est un anneau en matière plastique avec lequel la paroi (17) est enrobée dans une entaille (28) circonférentielle en forme de rainure.

4. Détecteur de proximité selon l'une des revendications précédentes, **caractérisé en ce qu'**il est conçu pour être enclavé dans un environnement de montage, notamment dans une bague de réglage (26).

5. Détecteur de proximité selon l'une des revendications précédentes, **caractérisé en ce qu'**un écart axial entre le fond (13) du creuset et les secteurs d'électrode (18) est réduit localement.

6. Détecteur de proximité selon l'une des revendications précédentes, **caractérisé en ce qu'**il possède un creuset plat (12) monobloc avec plaque et paroi (17), en céramique en technologie de moulage par injection.

7. Détecteur de proximité selon l'une des revendications précédentes, **caractérisé en ce qu'**il existe une mortaise (23) circonférentielle de forme annulaire le long du fond (13), munie d'un bourrelet (22) de forme annulaire qui vient se rattacher dans le sens radial à l'extérieur de celle-ci, faisant également saillie de la paroi (17) dans le sens radial et s'élevant au-dessus du plan de la surface de commande (14).

8. Détecteur de proximité selon la revendication précédente, **caractérisé en ce que** le bourrelet (22) se transforme en la paroi (17) directement, mais en le fond (13) avec une mortaise (23) de forme triangulaire ou rectangulaire qui entoure celui-ci.

9. Détecteur de proximité selon l'une des revendications précédentes, **caractérisé en ce que** la surface de commande (14) et/ou un bourrelet (22) qui entoure celle-ci possède des marquages optiques ou tactiles associés géométriquement aux secteurs d'électrode (18).

10. Détecteur de proximité selon l'une des revendications précédentes, **caractérisé en ce qu'**une fibre optique (19) circonférentielle ou une séquence de sources de lumière est disposée derrière le fond (13) du creuset le long de son bord.
